# EUROPEAN PATENT APPLICATION

(11) **EP 4 148 916 A1**
(43) Date of publication of application: **15.03.2023**
(21) Application number: 20934852.3
(22) Date of filing: 05.05.2020
(51) Int. Cl.: H01R 13/70, H01R 24/68, H01R 31/06

(54) **SMART ELECTRICAL SOCKET WITH TEMPERATURE SENSOR**

(71) Applicant: STEMY ENERGY, S.L., 28020 Madrid (ES)
(72) Inventor: SANCHEZ MIRALLES, Alvaro, 28020 Madrid (ES); BOAL MARTIN-LARRAURI, Jaime, 28023 Madrid (ES); MARTIN MARTINEZ, Francisco María, 28015 Madrid (ES); RODRIGUEZ - MORCILLO GARCIA, Carlos, 28023 Madrid (ES); MARTIN LOPO, Miguel Manuel, 28015 Madrid (ES); VAZQUEZ BLANCO, Antonio, 27500 Chantada (ES)
(74) Representative: González-Mogena González, Inigo
(86) International application number: PCT/ES2020/070284
(87) International publication number: WO 2021/224511

(57) **Abstract**

The present invention discloses a smart plug device allowing for the temperature in the room in which it is installed to be detected. The device comprises a housing (1) substantially of a rectangular-parallelepiped shape, wherein the front surface has a female connection (6) allowing an external element (13) to be plugged in and the rear surface includes pins (11) for its connection to a power source. Furthermore, it incorporates a temperature module composed of a temperature sensor (2) arranged on the lower part of the metallic internal structure (10) and cut-outs (2.1) in the printed circuit board (PCB) (20) to insulate the heat generated by said board; a consumption sensing circuit (4) arranged facing the printed circuit board (PCB) (20) and facing away the temperature sensor (2); a load actuator (3) formed by at least one relay; a power source (14) and a wireless communication module (5) arranged on the internal structure (PCB) (10).

## Description

### OBJECT OF THE INVENTION

This invention discloses a smart plug incorporating a temperature sensor which, together with consumption measurement of the appliance that is connected, allows this device to be utilised as an efficient temperature controller capable of optimising the power consumption and reducing the monetary and energy expenditure when a room's temperature is managed.

### BACKGROUND OF THE INVENTION

A smart plug device relates to a device connected to a receptacle and a plug of an electronic device between the receptacle and the plug of the electronic device to monitor the energy usage status of the electronic device or supply or interrupt the electric energy from the electronic device in response to a control command from a user's device.

Electrical measuring devices are commonly used in households, offices, industrial plants or particular places to monitor the general energy consumption of the same. In order to measure energy consumption accurately, electrical measuring devices can be equipped to every electrical appliance. However, this method is costly and impracticable. Occasionally, a compromise measuring method of energy consumption is utilised, wherein the electrical measuring devices are fitted to an electrical socket solely to measure electrical appliances receiving energy from this electrical socket. As would expected, this way does not accurately measure operations or standby energy consumption of each of the electrical appliances.

The American patent application US20180337495 discloses an electrical device comprising a housing including a surface facing forwards with electrical sockets, set out for the set of supply pins of a smart plug to be plugged in; an activation pin and a set of detection pins, configured to form a circuit with a set of feedback pins of a smart plug when the set of supply pins is plugged into the electrical sockets; and an identification code module, configured to obtain an identification code of an electrical appliance, from the circuit to which the smart plug belongs. The device incorporates a passive infrared movement sensor (PIR) arranged inside the housing, employed to detect intrusions and occupation in the proximity of the appliance and one or more temperature sensors arranged inside the housing, which would take readings on ambient air and process data inside the electrical device. The user can require to configure the target temperature and humidity in such a manner that these correspond to those of a desired environment. Furthermore, if it detects a severe temperature, the temperature sensor communicates with the main unit of the controlling device by means of a notification to the user's external device.

The American patent application US20170310809 shows a monitor indicating air quality incorporated into a smartphone, comprising a housing body, in which a sensor is fitted inside the housing body to obtain air quality parameters; a plug is provided in the housing body to be connected to the smartphone; a sensor signal output terminal and a supply input terminal are connected to the plug; wherein no energy source or managing module of an energy source is fitted inside the housing body; no displaying module is fitted in the housing body; wherein a signal processing circuit is also fitted inside the housing body, while the sensor is connected to the signal processing circuit; the signal processing circuit is connected to the plug by means of an OTG module (On-The-Go); wherein the OTG module obtains energy from the smartphone and communicates data with the smartphone, which has an OTG function, in such a manner that the smartphone having the OTG function obtains data from the sensor. The air quality monitor supported by the smartphone incorporates two sensors inside the housing body, and both sensors are selected from a temperature sensor, a humidity sensor, a PM2.5 sensor, a formaldehyde sensor and a CO₂ sensor.

The preceding documents show smart plugs comprising a housing with means for the connection to a source and means for the connection to other devices and equipped with temperature sensors as well. In both documents, it can be seen that the use of the temperature sensors allows air quality and humidity to be determined yet does not relate in any case to the fact that an efficient control of the temperature in the room is allowed in such a manner that power consumption can be optimised and energy expenditure can be reduced. The main novelty of the invention consists in measuring ambient temperature with no influence from power consumption, which increases heating in the appliance.

Furthermore, this invention includes a wireless communication module, meaning that the plug can be controlled remotely. By knowing the temperature in the room in which the smart plug is located, it allows for the energy consumption of the appliance connected to the same to be overseen, i.e., by means of an application wirelessly connected to the communication module of the smart plug, energy consumption can be controlled and thus optimised.

### DESCRIPTION OF THE DRAWINGS

To complement this description and for a greater understanding of the features of the invention in accordance with an exemplary preferred embodiment of the same, a set of drawings is attached as an integral part of said description, these drawings merely provided for illustrative and non-limiting purposes:

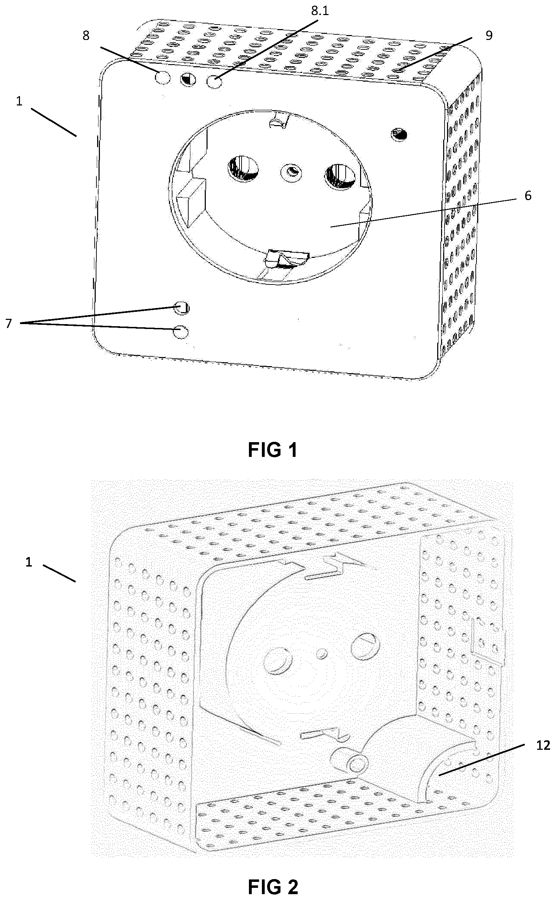

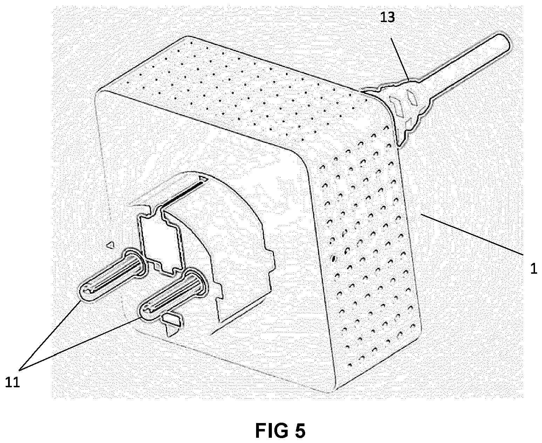

Figure 1/5.- shows a front view of the smart plug according to this invention, in which the housing (1), the plurality of orifices (9) in the lateral surfaces and the rest of elements indicating the on and off modes are shown.
Figure 2/5.- shows an internal view of the housing (1), in which the chamber (12) where the temperature sensor (2) will be located to be insulated against the rest of the plug is shown in detail.

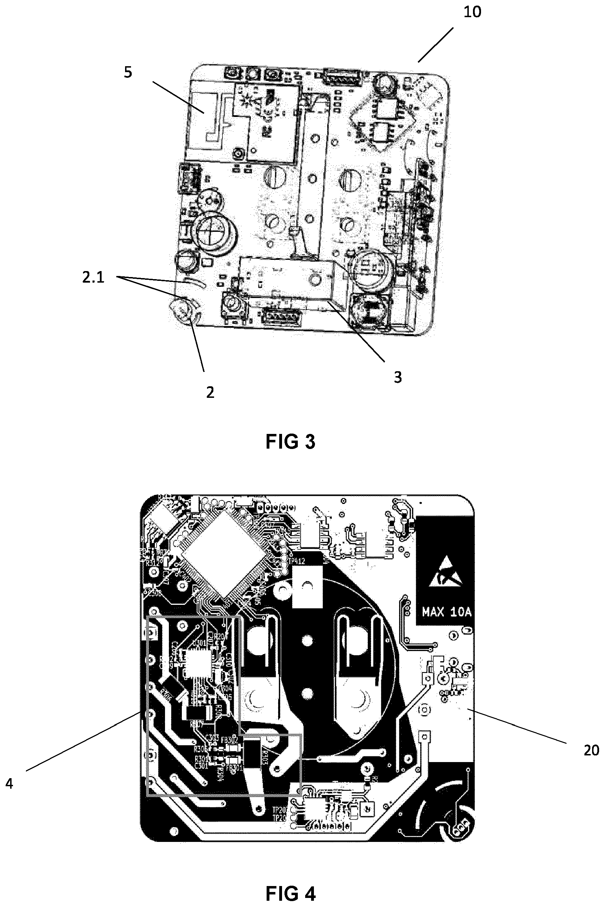

Figure 3/5.- shows a view of the metallic internal structure (10) coupled to the printed circuit board (PCB) (20), in which the internal elements are indicated.
Figure 4/5.- shows a view of the printed circuit board (PCB) (20), in which the section including the energy consumption sensing circuit (4) is shown in detail using a dotted and dashed line.
Figure 5/5.- shows a perspective view of the different elements the smart plug is composed of, in which the pins (11) for its connection to a power source and an external element (13) plugged into this smart plug are shown.

### BRIEF DESCRIPTION OF THE INVENTION

This invention discloses a smart plug device allowing for the temperature in the room in which it is installed to be detected regardless of the heat generated by the same. The smart plug is constituted by a housing including pins for the connection. The object of the invention relies on this smart plug incorporating a temperature sensor which, alongside the consumption measurement of the appliance that is connected, allows this device to be used as an efficient temperature controller capable of optimising power consumption and thus reducing the money and energy expenditure when a room's temperature is managed.

The smart plug is constituted by a housing substantially of a rectangular-parallelepiped shape including a plurality of orifices drilled into the lateral surfaces, wherein the front surface has a female connection allowing an external element to be plugged in and the rear surface incorporates pins for its connection to a power source. The smart plug includes means for controlling and switching off, means for controlling energy consumption and means for a wireless communication.

### PREFERRED EMBODIMENT OF THE INVENTION

This invention is grounded on the fact that the smart plug incorporates a temperature sensor (2) monitoring the temperature in the room in which the device is installed, in such a manner that, through knowing the temperature, energy expenditure can be managed and, therefore, energy consumption and monetary expenditure can be reduced.

The smart plug featuring a temperature sensor according to this invention comprises a housing (1) substantially of a rectangular-parallelepiped shape, wherein the front surface has a female connection (6) allowing an external element (13) to be plugged in and the rear surface includes pins (11) for its connection to a power source. In the housing (1), a plurality of orifices has been drilled into the lateral surfaces of the same in order to maintain ventilation over the internal elements.

The device incorporates a temperature module composed of a temperature sensor (2) arranged on the lower part of the internal board structure (PCB) (10) to avoid convection heat and cut-outs (2.1) in the printed circuit board (PCB) (20) to insulate the heat generated by said board; a consumption sensing circuit (4) arranged facing the printed circuit board (PCB) (20) and facing away the temperature sensor (2), in such a manner that this consumption sensing circuit (4) is located furthest away from the temperature sensor (2) to avoid interference resulting from the heat generated by conduction. Temperature measuring in the room in which the smart plug is located, together with the consumption measurement of the appliance that is connected to the plug, allows for this device to be used as an efficient temperature controller capable of optimising power consumption and thus reducing energy and monetary expenditure when a room's temperature is managed.

The smart plug equipped with a temperature sensor includes a load actuator (3) formed by at least one relay allowing to control load and arranged with its power part being as spaced apart as possible from the ambient temperature sensor to avoid the heat by conduction through the PCB, and a wireless communication module (5) arranged on the internal board structure (PCB) (10) allowing for the smart plug to be controlled from other devices by means of suitable applications and as spaced apart as possible from the ambient temperature sensor to avoid the heat by conduction through the PCB.

Furthermore, a power source (14) is available entrusted with supplying energy to the electronics, located as spaced apart as possible from the ambient temperature sensor to avoid the heat by conduction through the PCB.

The housing (1) internally incorporates a cavity (12) in which the temperature sensor (2) is located. This allows for the insulation of the temperature sensor (2) from the heat generated by convection and radiation from the entire set, i.e., the rest of elements included in the smart plug.

The front face of the housing (1) includes light indicators (7) to indicate the switching on and off of the plug and has buttons (8; 8.1) for switching on and erasing data on the top of said front face.

This invention through its wireless communication module (5) allows to be controlled remotely. Through knowing the temperature in the room in which the smart plug is located, energy consumption of the appliance connected to the same may be controlled, i.e., it is possible to control and optimise energy consumption by means of an application acting on the communication module of the smart plug.

## Claims

1. A smart plug with a temperature sensor comprising a housing (1) substantially of a rectangular-parallelepiped shape, wherein the front surface has a female connection (6) allowing an external element (13) to be plugged in and the rear surface includes pins (11) for its connection to a power source, **characterised in that** it incorporates a temperature module composed of a temperature sensor (2) arranged on the lower part of the internal structure (PCB) (10) and cut-outs (2.1) in the printed circuit board (PCB) (20) to insulate the heat by conduction generated by said board; a consumption sensing circuit (4) arranged facing the printed circuit board (PCB) (20) and facing away the temperature sensor (2); a load actuator (3) formed by at least one relay; a power source (14) and a wireless communication module (5) arranged on the internal structure (PCB) (10).

2. The smart plug with a temperature sensor according to claim 1, **characterised in that** the housing (1) includes a plurality of orifices (9) drilled into the lateral surfaces to dissipate the heat.

3. The smart plug with a temperature sensor according to claim 1, **characterised in that** the housing (1) internally incorporates a cavity (12) to insulate the temperature sensor (2) from the generated heat.

4. The smart plug with a temperature sensor according to claim 1, **characterised in that** the front part of the housing (1) includes light indicators (7) to indicate the switching on and off of the plug.

5. The smart plug with a temperature sensor according to claim 1, **characterised in that** the front part of the housing (1) has buttons (8; 8.1) located on the top for switching on and erasing data.
